# EUROPEAN PATENT APPLICATION

(11) **EP 2 400 497 A2**
(43) Date of publication of application: **28.12.2011**
(21) Application number: 11152198.5
(22) Date of filing: 26.01.2011
(51) Int. Cl.: G11C 5/14, G11C 11/4074

(54) **Control circuit and electronic device using the same**

(30) Priority: 25.06.2010 CN 201010209758
(71) Applicant: Hong Fu Jin Precision Industry (ShenZhen) Co., Ltd., Longhua Town, Bao'an District Shenzhen City Guangdong 518109 (CN); Hon Hai Precision Co., Ltd, Tu-cheng City, Taipei Hsien Taiwan, ROC (CN)
(72) Inventor: Wang, Tao, 518109, Shenzhen Guangdong (CN)
(74) Representative: Gray, John James

(57) **Abstract**

An electronic device (100) connected to an external storage device (200) and stores data transmitted from the storage device (200), the electronic device (100) comprising a power supply (10), a control circuit (20) and a storage unit (30). The power supply (10) supplies a voltage to the storage unit (30) via the control circuit (20). The control circuit (20) comprises a protection unit (203). The control circuit (20) generates a first control signal when the output voltage of the protection unit (203) is less than a working voltage of the storage unit (30), and generates a second control signal when the output voltage of the protection unit (203) is at least a working voltage of the storage unit (30). The storage unit (30) is disabled in response to the first control signal, and enabled in response to the second control signal.

## Description

### 1. Field of the Disclosure

The present disclosure relates to a control circuit and particular to an electronic device using a control circuit.

### 2. Description of Related Art

When voltage supplied to a SDRAM (synchronous dynamic random access memory) module is less than 2.0V, data stored in the SDRAM may change. Therefore, when the electronic device decodes the changed data information in the SDRAM, erroneous information is provided thereto.

Therefore, there is room for improvement in the art.

### SUMMARY

According to an exemplary embodiment of the invention, an electronic device connected to an external storage device and stores data transmitted from the storage device, the electronic device comprising a power supply, a control circuit and a storage unit. The power supply supplies a voltage to the storage unit via the control circuit. The control circuit comprises a protection unit. The control circuit generates a first control signal when the output voltage of the protection unit is less than a working voltage of the storage unit, and generates a second control signal when the output voltage of the protection unit is at least a working voltage of the storage unit. The storage unit is disabled in response to the first control signal, and enabled in response to the second control signal.

### BRIEF DESCRIPTION OF THE DRAWINGS

Many aspects of the embodiments can be better understood with references to the following drawings. The components in the drawings are not necessarily drawn to scale, the emphasis instead being placed upon clearly illustrating the principles of the embodiments. Moreover, in the drawings, like reference numerals designate corresponding parts throughout two views.

FIG. 1 is a block diagram of an electronic device in accordance with one exemplary embodiment.

FIG. 2 is a circuit diagram of the electronic device of FIG. 1 in accordance with the exemplary embodiment.

### DETAILED DESCRIPTION

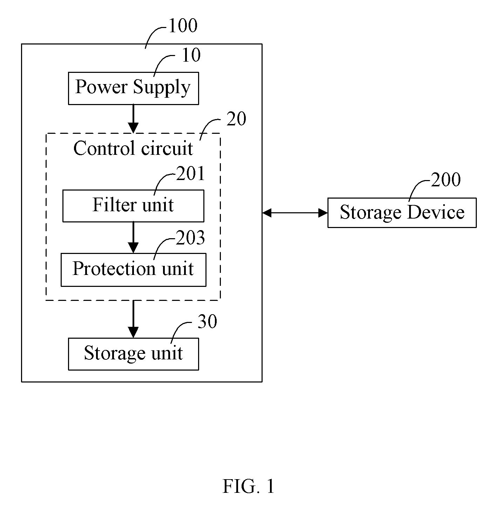

Referring to FIG. 1, an electronic device 100 connects with an external storage device 200 in a wired or a wireless manner. Data information of the storage device 200 can be transmitted to the electronic device 100 and stored in the electronic device 100. The electronic device 100 may be a DVD player or a notebook computer. The storage device 200 may be an optical disc or a mobile hard disk.

The electronic device 100 includes a power supply 10, a control circuit 20 and storage unit 30. The power supply 10 provides a voltage to the storage unit 30 via the control circuit 20. The storage unit 30 is a SDRAM. The storage unit 30 defines a working voltage such as 2.0V.

The control circuit 20 includes a filter unit 201 and a protection unit 203. The filter unit 201 filters noise from the power supply 10, and provides the filtered voltage to the protection unit 203.

The protection unit 203 generates a control signal to the storage unit 30 to protect the storage unit 30. The protection unit 203 also provides an output voltage to the storage unit 30. If the output voltage of the protection 203 is less than the working voltage, the protection unit 203 generates a first control signal. If the output voltage of the protection 203 is at least the working voltage, the protection unit 203 generates a second control signal. In the embodiment, the first control signal is a low level signal and the second control signal is a high level signal.

The storage unit 30 is disabled in response to the first control signal, and enabled in response to the second control signal.

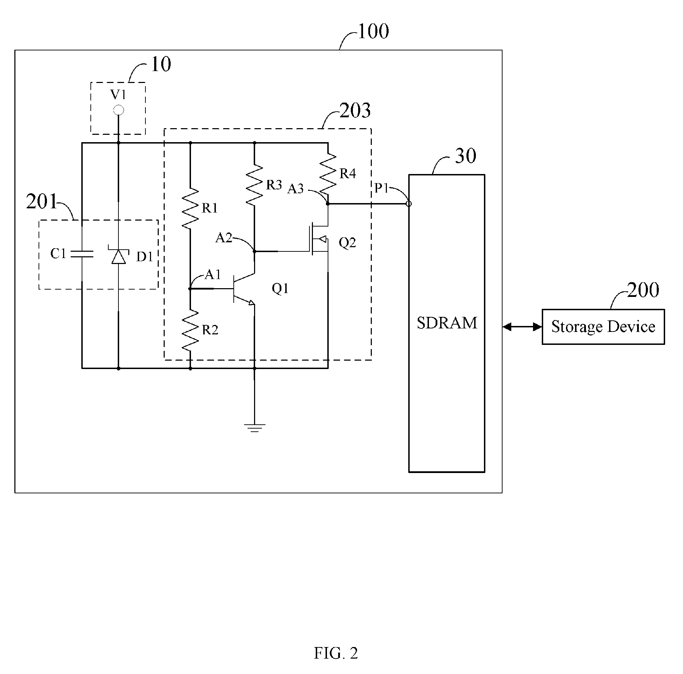

Referring to FIG. 2, the filter unit 201 includes a filtering capacitor C1 and a diode D1. The filtering capacitor C1 and a diode D1 electrically connects between the power supply 10 and ground in parallel. The anode of the diode D1 electrically connects with the power supply 10, the cathode of the diode D1 electrically connects to the ground. In the embodiment, the power supply 10 supplies 2.0V.

The protection unit 203 includes a first resistor R1, a second resistor R2, a third resistor R3, a fourth resistor R4, a first node A1, a second node A2, a third node A3, a first transistor Q1 and a second transistor Q2. The first resistor R1 is connected between the power supply 10 and the first node A1 and the second resistor R2 is connected between the first node A1 and ground. The third resistor R3 is connected between the power supply 10 and the second node A2. The fourth resistor R4 is connected between the power supply 10 and the third node A3. A base of the transistor Q1 is connected to the first node A1. A collector of the first transistor Q1 is connected to the second node A2. An emitter of the first transistor Q1 is grounded. The first transistor Q1 is a npn type bipolar junction transistor. A gate of the second transistor Q2 is connected to the second node A2. A drain of the second transistor Q2 is connected to the third node A3. A source of the second transistor Q2 is grounded. The second transistor Q2 is an n-channel enhancement type metal oxide semiconductor field effect transistor.

The storage unit 30 includes a port P1 to receive the control signal of the protection unit 203. The port P 1 is electrically connected to the third node A3. When the port P1 receives the first control signal, the storage unit 30 is disabled, when the port P1 receives the second control signal, the storage unit 30 is enabled.

Resistors R1 and R2 forms a voltage divider circuit and when the voltage of the power supply 10 is less than 2.0V, the difference in voltage between the first node A1 and the emitter of the second transistor Q1 is less than 0.7V. The transistor Q1 is turned off. The voltage at A2 will be at the same voltage as the power supply 10 voltage. The difference in voltage between the second node A2 and the source of the second transistor Q2 exceeds 0.7V. The second transistor Q2 is turned on. The voltage of the third node A3 is pulled to ground. The protection unit 203 generates the first control signal. The storage unit 30 is disabled according to the first control signal.

When the voltage of the power supply 10 is at least 2.0V, the difference in voltage between the first node A1 and the emitter of the second transistor Q1 exceeds 0.7V. The transistor Q1 is turned on. The voltage of the second node A2 is pulled to ground. The second transistor Q2 is turned off. The voltage of the third node A3 will be at the same voltage as the power supply 10 voltage. The protection unit 203 generates the second control signal. The storage unit 30 is enabled according to the second control signal.

As described, when the output voltage of the protection unit 203 is less than the working voltage, the storage unit 30 is disabled; and when the output voltage of the protection unit 203 is at least the working voltage, the storage unit 30 is enabled. Therefore, data information is stored in the storage unit 30 only when the output voltage of the protection unit 203 is at least the working voltage, and thus remains intact.

It is to be understood, even though information and advantages of the present embodiments have been set fourth in the foregoing description, together with details of the structures and functions of the present embodiments, the disclosure is illustrative only; and that changes may be made in detail, especially in matters of shape, size, and arrangement of parts within the principles of the present embodiments to the full extent indicated by the broad general meaning of the terms in which the appended claims are expressed.

## Claims

1. An electronic device connecting to an external storage device comprising:
a storage unit adapted to receive data information transmitted by the external storage device;
a control circuit with a protection unit, the protection unit adapted to generate a first control signal when the output voltage of the protection unit is less than a working voltage of the storage unit; and generate a second control signal when the output voltage of the protection unit is at least the working voltage of the storage unit; a power supply for supplying a voltage;
a power supply for supplying a voltage to the storage unit via the protection unit which provides the output voltage thereof to the storage unit; and
wherein the storage unit is disabled in response to the first control signal, and enabled in response to the second control signal.

2. The electronic device of claim 1, wherein the protection unit includes a first resistor, a second resistor, a third resistor, a fourth resistor, a first node, a second node, a third node, a first transistor and a second transistor, the first resistor is connected between the power supply and the first node and the second resistor is connected between the first node and ground, the third resistor is connected between the power supply and the second node, the fourth resistor is connected between the power supply and the third node, a base of the transistor is connected to the first node, a collector of the first transistor is connected to the second node, an emitter of the first transistor is grounded, a gate of the second transistor is connected to the second node, a drain of the second transistor is connected to the third node, a source of the second transistor is grounded.

3. The electronic device of claim 2, wherein the first transistor is a npn type bipolar junction transistor.

4. The electronic device of claim 2, wherein the second transistor is an n-channel enhancement type metal oxide semiconductor field effect transistor.

5. The electronic device of claim 2, wherein the storage unit includes a port adapted to receiving the control signal, the port is connected to the third node.

6. The electronic device of any preceding claim, wherein the control circuit further comprises a filter unit, the filter unit is adapted to filter noise from the power supply and provide a filtered voltage to the protection unit.

7. The electronic device of claim 6, wherein the filter unit includes a filtering capacitor and a diode, the filtering capacitor and the diode are connected between the power supply and ground.

8. The electronic device of any preceding claim, wherein the first signal is a low level signal; the second control signal is a high level signal.

9. The electronic device of any preceding claim, wherein the working voltage is 2.0V.

10. A control circuit connecting to a power supply, the control circuit adapted to generate a control signal to a storage unit comprising:
a protection unit adapted to generate a first control signal when the output voltage of the protection unit is less than a working voltage of the storage unit; and generate a second control signal when the output voltage of the protection unit is at least the working voltage of the storage unit; and
wherein the storage unit is disabled in response to the first control signal, and enabled in response to the second control signal.

11. The control circuit of claim 10, wherein the working voltage is 2.0V.

12. The control circuit of any of claims 10 to 11, wherein the control circuit further comprises a filter unit, the filter unit adapted to filter noise from the power supply.

13. The control circuit of claim 11, wherein the protection unit includes a first resistor, a second resistor, a third resistor, a fourth resistor, a first node, a second node, a third node, a first transistor and a second transistor, the first resistor is connected between the power supply and the first node and the second resistor is connected between the first node and ground, the third resistor is connected between the power supply and the second node, the fourth resistor is connected between the power supply and the third node, a base of the transistor is connected to the first node, a collector of the first transistor is connected to the second node, an emitter of the first transistor is grounded, a gate of the second transistor is connected to the second node, a drain of the second transistor is connected to the third node, a source of the second transistor is grounded.

14. The control circuit of claim 13, wherein the first transistor is a npn type bipolar junction transistor, the second transistor is an n-channel enhancement type metal oxide semiconductor field effect transistor.

15. The control circuit of any of claims 10 to 14, wherein the first signal is a low level signal, the second control signal is a high level signal.
